# EUROPÄISCHE PATENTANMELDUNG

(11) **EP 2 325 354 A1**
(43) Veröffentlichungstag der Anmeldung: **25.05.2011**
(21) Anmeldenummer: 10191666.6
(22) Anmeldetag: 18.11.2010
(51) Int. Cl.: C30B 11/00, C30B 15/14, C30B 15/30

(54) **Kristallisationsanlage und Kristallisationsverfahren**

(30) Priorität: 18.11.2009 DE 102009046845
(71) Anmelder: Steremat Elektrowärme GmbH, 12435 Berlin (DE); Forschungsverbund Berlin E.V., 12489 Berlin (DE)
(72) Erfinder: Trautmann, Veit, 12623, Berlin (DE); Rudolph, Peter, 12529, Schönefeld (DE); Kießling, Frank-Michael, 10439, Berlin (DE); Fornari, Roberto, 12489, Berlin (DE)
(74) Vertreter: Gulde Hengelhaupt Ziebig & Schneider

(57) **Zusammenfassung**

Die Erfindung betrifft eine Kristallisationsanlage mit elektrischer Heizeinrichtung, die als ein um eine Tiegelwand (41) eines Tiegels (40) herum positionierbares Heizer-Magnet-Modul (100) ausgeführt ist.

In einem Innenraum (10) eines ersten Heizer-Magnet-Modules (100) ist ein zweites, ebenfalls um die Tiegelwand (41) des Tiegels (40) herum positionierbares Heizer-Magnet-Modul (200) vorgesehen.

Ferner ist ein Kristallisationsverfahren vorgesehen.

## Beschreibung

Die Erfindung betrifft eine Kristallisationsanlage und ein dazugehöriges Kristallisationsverfahren.

Als Kristallisationsverfahren werden allgemein Verfahren zur Gewinnung einer kristallinen Phase bzw. einer kristallinen Substanz als End- oder Zwischenprodukt für die Verwendung in der Industrie verstanden. Mit dem Begriff Kristallisationsverfahren soll auch die Kristallzüchtung - die künstliche Herstellung von polykristallinen Materialien und die Züchtung von Einkristallen - umfasst werden.

Die heutigen und zukünftigen Anforderungen an die Kristallzüchtung konzentrieren sich zunehmend auf die Durchsatzerhöhung pro Züchtungsdurchlauf bei gleichzeitiger Verbesserung der Materialqualität. Die betrifft in hohem Maße die Herstellung von einkristallinen Siliziumstäben und polykristallinen Siliziumblöcken für die Gewinnung von Solarwafern. Eine solche Ausrichtung erfordert die Vergrößerung der Schmelzvolumina, was zunehmend schädliche Konvektionsflüsse mit Temperaturfluktuationen sowie unerwünschte Durchbiegungen und morphologische Instabilität der fest-flüssig - Phasengrenze (Kristallisationsfront) mit sich bringt. Als eine wesentliche Kontrollmaßnahme zur Gegensteuerung erweist sich der Einsatz magnetischer Felder, mit denen es gelingt, Konvektionen einzudämmen, stationäre Durchmischungen zu erzeugen und die Kristallisationsfront einzuebnen. Standardmäßig werden die Magnetfelder in Spulen erzeugt, die um die Kessel der Züchtungsanlagen herum angeordnet sind (D.T.J. Hurle, Handbook of Crystal Growth, Vol. 2a, Elsevier, North-Holland 1994, p. 259). Allerdings ist der konstruktive und energetische Aufwand solcher externer Anordnungen sehr hoch, da die erzeugte magnetische Induktion auf Grund der Abschirmung in den Kesselwänden bis zu einer Größenordnung höher als in der Schmelze erforderlich sein muss (O. Klein et al., J. Crystal Growth 310 (2008) 1523). Es werden deshalb Anordnungen vorgeschlagen, bei denen die Magnetfelder innerhalb des Kessels, um den Schmelztiegel herum, generiert werden. Eine besonders energetisch und konstruktiv günstige Lösung ist die gleichzeitige Erzeugung der magnetischen Lorentzkräfte im ohnehin vorhandenen Heizer, der den Schmelztiegel in unmittelbarer Nähe umgibt (P. Rudolph, J. Crystal Growth 310 (2008) 1298).

Bekannt ist das Prinzip zur gleichzeitigen Erzeugung eines Temperaturprofils und Magnetfeldes für den Einsatz in der Kristallzüchtung. Die meisten betreffen die Erzeugung eines rotierenden (azimutal wandernden) Feldes. Nach Fujimori und Ayusawa (DE 21 07 646), Ayusawa (JP 6 026 4391), Hull (IBM Technical Disclosure Bulletin Vol. 23 (1980) 2756), Hoshikawa et al. (Jpn. J. Appl. Phys. 19 (1980) L33) und Kim et al. (IBM Technical Disclosure Bulletin Vol. 25 (1982) 2277; DE 37 50 382) werden den Schmelztiegel umschließende, aus drei gleichen Kreisbögen bestehende hohlzylindrische, einlagig mäanderförmig geschlitzte Widerstandsheizer aus Graphit mit einem phasenversetzten RST-Dreiphasenstrom so durchflossen, dass die Anordnung neben einer bestimmten Wärmemenge auch ein rotierendes Magnetfeld erzeugt. In der Schrift DE 35 27 387 wird eine solche elektromagnetische Rührvorrichtung in ihrer Effektivität durch das Einspeisen mehrerer Drehströme unterschiedlicher Frequenz gesteigert.

Longitudinale Magnetfelder, die ein toroidförmiges Lorentzkraftfeld in die Schmelze einkoppeln und besonders zur Dämpfung der Konvektion sowie Einebnung der Phasengrenze geeignet sind, werden in einlagigen Heizspulen zumeist aus Graphit mit spiralförmig umlaufendem Schlitz erzeugt. Besteht die Spule aus einem einzigen Abschnitt mit zwei Stromzuleitungen, je eines an ihrem oberen und unteren Ende, entsteht bei Stromdurchfluss neben Joule'scher Wärme auch ein stationäres Magnetfeld. Solche Heizer-Magnet-Anordnungen werden von Grimes (US 5,571,320, EP 0 628 645) und Giess et al. (IBM Technical. Disclosures Bull. 26 (1984) 4716) beschrieben. Soll ein von oben nach unten oder von unten nach oben wanderndes Magnetfeld erzeugt werden, das die Konvektionsflüsse und damit den Verunreinigungsabtransport von der Kristallisationsfront weit besser als ein statisches Feld kontrolliert, wird der einlagige spiralförmige Strompfad in mindestens zwei, üblicherweise drei oder mehr übereinander folgende einlagige Spulenabschnitte unterteilt, die mit einem phasenverschobenen Wechselstrom durchflossen werden (DE 101 02 126, EP 1 22555, US 2002/0092461 A1, US 5,196,085, EP 1 676 299, US 7,179,331, DE 10 2007 020 239, DE 10 2007 028 547, DE 10 2007 028 548, DE 10 2007 046 409). Eine günstige entkoppelte Kontrolle des Wärme- und Magnetfeldes wird bei gleichzeitiger Einspeisung von Gleich- und Wechselstrom respektive erzielt (DE 37 50 382, EP 1 676 299, DE 196 52 543). Um eine geringstmögliche Zahl elektrischer Zuführungen an solchen Spulensystemen aus vielen Abschnitten zu erzielen, werden spezielle Phasenverschiebungen und - umkehrungen elektronisch gelöst (DE 10 2007 020 239). Eine thermische und magnetische Asymmetrie wird durch horizontale oder weiträumig rechtwinklig abgeknickte Stromschienen garantiert (DE 10 2007 028 547). In der Schrift DE 10 2007 028 547 wird die Notwendigkeit von isolierenden Stabilisierungselementen beschrieben, die die Windungsabstände stabil und äquidistant gestalten. Durch variierende Windungsquerschnitte und -durchmesser können Temperatur- und Lorentzkraftfeld an jede beliebige Schmelztiegelform und Züchtungsprozessführung optimal angepasst werden (DE 10 2007 028 548).

All diese bisher beschriebenen Lösungen besitzen einen wesentlichen konstruktivtechnischen Nachteil - die *einlagige* Ausführung der Strombahnen. Eine notwendige gleichzeitige voneinander unabhängige Erzeugung und Kontrolle Joule'scher Wärme für den Schmelz- und Kristallisationsprozess und magnetischer Induktion für die Konvektionsbeeinflussung in einer einlagigen Spule, erfordert einen möglichst großen Windungsquerschnitt Q (Q = h x b, wobei h = Windungshöhe, b = Windungsbreite) mit einem geringen elektrischen Bahnwiderstand, um große Stromstärken für hohe magnetische Induktionen ohne Entstehung zusätzlicher Wärmeverluste, die die Gesamtwärmebilanz des Heizers stören könnten, einspeisen zu können. Dies erweist sich als besonders wichtig, wenn das zu kristallisierende Material einen niedrigen Schmelzpunkt aufweist, wie z.B. GaSb (Schmelzpunkt: 712°C) und InSb (Schmelzpunkt: 525°C) und für ein hinreichend großes Lorentzkraftfeld zu viel nutzlose Zusatzwärme erzeugt würde. Eine entgegengesetzte Situation entsteht bei hochschmelzenden Stoffen, wie z.B. Si (Schmelztemperatur:1410°C) oder GaP (Schmelztemperatur: 1467°C), wo viel Wärme mit einem effektiven Durchgriff erzeugt werden muss, um große Materialvolumina aufzuschmelzen. Hier wäre ein kleiner Windungsquerschnitt von Vorteil, der aber für die Erzeugung hoher Lorentzkräfte abträglich ist. Grundsätzlich ist eine hohe Windungszahl für die Erzeugung hoher Magnetfelder vorteilhaft, so dass eine Lösung über Variation der Windungshöhe h ungünstig ist. Damit bliebe die Wahl einer entsprechend angepassten Windungsbreite b übrig. Die bisherigen o. g. Publikationen gehen davon aus, dass eine spiralförmige einlagige Ausführung aus einem Graphitvollzylinder gefertigt werden muss. Die Spiralschlitzung stellt dabei insbesondere bei großer Windungsbreite einen technisch anspruchvollen, teuren und auf die Werkzeugabmessung begrenzten Herstellungsschritt dar.

Des Weiteren ist prinzipiell eine gänzliche Entkopplung des Wärme- und Magnetfeldes in einer einlagigen Spule nicht möglich und lässt für Kristallzüchtungsvorgänge immer nur eine Kompromiss- an Stelle einer angestrebten Optimallösung zu.

Die Einspeisung mehrerer Wechselstromfelder unterschiedlicher Frequenz in eine einlagige spiral- oder mäanderförmig verlaufende Strombahn, wie z.B. in der Schrift DE 35 27 387 zur Erzielung einer verbesserten Mischung beschrieben, führt zur Entstehung von Zusatzfrequenzen, sog. "Seitenfrequenzen" (s. Handbücher der Elektrotechnik), die nicht in jedem Fall erwünscht sind und u.U. elektronisch aufwendig aus dem Spektrum herausgefiltert werden müssten.

Eine einlagige spiral- oder mäanderförmige Strombahn lässt die Erzeugung nur einer Magnetfeldkonfiguration zu - a) eines toroiden stationären Feldes bei Verwendung nur einer einzigen Spule (Spulenabschnittes), b) eines longitudinalen Wanderfeldes bei Unterteilung in mindestens zwei oder mehr vertikal aufeinander folgender (Spulen) Spulenabschnitte oder c) eines rotierenden Feldes bei Aufteilung der Spule in gegenüberliegende Kreisbahnpaare oder Verwendung mäanderförmig geschlitzter Spulenkörper. Bei Kristallisationsvorgängen erweist es sich aber zunehmend als vorteilhaft, stationäre und nicht-stationäre Magnetfelder zugleich zu erzeugen, wie es mit voneinander getrennten Vielspulenanordnungen außerhalb eines Züchtungsanlagenkessels auf allerdings sehr teurem Wege getestet wurde (V. Galindo et al., Energy Conv. and Management 43 (2002) 309; E. Tomzig et al., Mat. Sci. in Semicond. Processing 5 (2003) 347; A. Cramer et al., Electrical Review 11 (2008) 144).

Aufgabe der Erfindung ist es, eine Kristallisationsanlage und ein Kristallisationsverfahren bereitzustellen, mit dem die aufgezeigten Nachteile im Stand der Technik vermieden und dadurch die Qualität der herzustellenden Kristalle verbessert werden kann.

Die erfindungsgemäße Kristallisationsanlage mit elektrischer Heizeinrichtung, die als ein um eine Tiegelwand eines Tiegels herum positionierbares Heizer-Magnet-Modul ausgeführt ist, ist dadurch gekennzeichnet, dass in einem Innenraum eines ersten Heizer-Magnet-Moduls ein zweites, ebenfalls um die Tiegelwand des Tiegels herum positionierbares Heizer-Magnet-Modul vorgesehen ist.

Das erfindungsgemäße Kristallisationsverfahren aus elektrisch leitenden Schmelzen, bei dem eine in einem Tiegel enthaltene Schmelze mit vorgenannter Kristallisationsanlage elektrisch beheizt wird und zusätzlich wandernde auf die Schmelze einwirkende Magnetfelder erzeugt werden, ist dadurch gekennzeichnet, dass bezogen auf den Tiegel mindestens ein vertikal aufwärts oder abwärts wanderndes Magnetfeld und gleichzeitig ein weiteres azimutal rotierendes Magnetfeld erzeugt werden oder dass bezogen auf den Tiegel ein azimutal rotierendes Magnetfeld und gleichzeitig ein weiteres stationäres Magnetfeld erzeugt werden oder dass ein erstes vertikal aufwärts oder abwärts wanderndes Magnetfeld und gleichzeitig mindestens ein weiteres vertikal aufwärts oder abwärts wanderndes Magnetfeld erzeugt werden.

Unter einem Heizer-Magnet-Modul wird die Kombination aus elektrischer Heizvorrichtung mit einem Magnetfeldgenerator verstanden. Die Heizvorrichtung besteht aus einer einzelnen Spule oder vorzugsweise aus einer Mehrspulenanordnung von mindestens zwei axial übereinander angeordneten, meist zylindrischen Spulen aus Graphit, die mit Wechselstrom und/oder Gleichstrom gespeist werden können. Die Spule(n) bilden gleichzeitig den Magnetfeldgenerator.

Die so aufgebaute Heizvorrichtung befindet sich innerhalb des Hochdruckkessels der Kristallisationsanlage und umschließt die Schmelztiegelwand. Mit ihr wird der Tiegel beheizt und es werden stationäre, azimutal rotierende oder vertikal aufwärts oder abwärts wandernde Magnetfelder erzeugt.

Die Erfindung bietet eine Lösung für das bisher technisch schwierige Problem der Herstellung einer (Mehr-)Spulenanordnung mit großer Windungsbreite b der Spulen aus einem einzigen Zylinderstück, indem zwei oder mehrere Heizer-Magnet-Module ineinander gesteckt werden, deren Spule(n) jeweils relativ geringe Windungsbreiten b aufweisen. Wenn die Heizer-Magnet-Module gegeneinander nicht elektrisch isoliert sind und über gemeinsame elektrische Kontakte gespeist werden, durchläuft der Strom zur Magnetfelderzeugung die Windungen der ineinander gesteckten Heizer-Magnet-Module zugleich (parallel), was auf Grund des summarischen Windungsquerschnittes und verringerten Gesamtwiderstandes eine erhöhte Stromstärke und damit stärkeres Magnetfeld ohne übermäßige Wärmeerzeugung ermöglicht. Auf diese Weise kann eine "zwei- oder mehrlagige" Ausführung der Strombahnen erreicht werden.

Ein weiterer Vorteil der Erfindung ist der, dass mindestens zwei verschiedene Magnetfeldkonfigurationen (stationäre, vertikal aufwärts- und abwärts wandernde und azimutal rotierende Magnetfelder) gleichzeitig erzeugt werden können. Das kann beispielsweise mit folgendem Aufbau erreicht werden: Die Spulen der ineinander gesteckten und elektrisch voneinander isolierten Heizer-Magnet-Module sind spiralförmig aufsteigend geschlitzt, wobei ein Heizer-Magnet-Modul aus lediglich einer einzigen Spule besteht. Während im Heizer-Magnet-Modul, das lediglich eine Spule aufweist, bei Gleichstromversorgung ein stationäres Magnetfeld erzeugt wird, entsteht bei phasenverschobener Wechselstromeinspeisung in dem zweiten als Mehrspulenanordnung aufgebauten Heizer-Magnet-Modul ein magnetisches Wanderfeld.

Eine bevorzugte Ausführungsform der erfindungsgemäßen Kristallisationsanlage ist dadurch gekennzeichnet, dass weitere Heizer-Magnet-Module vorgesehen sind, die in Innenräumen eines jeweils vorhergehenden Heizer-Magnet-Moduls positionierbar sind.

Erfindungsgemäß ist vorgesehen, dass die Kristallisationsanlage mehr als zwei ineinander gesteckte Heizer-Magnet-Module aufweisen kann, die den Tiegel seitlich umschließen.

In einer anderen bevorzugten Ausführungsform der erfindungsgemäßen Kristallisationsanlage ist vorgesehen, dass das erste Heizer-Magnet-Modul aus einer Spule oder aus zwei oder mehr übereinander angeordneten Spulen mit spiralförmigen oder stufenförmigen Windungen gebildet ist.

Die Kristallisationsanlage wird vorzugsweise mit zwei ineinander gesteckten Heizer-Magnet-Modulen betrieben. Es sind verschiedene Varianten von Spulenanordnungen für die beiden Heizer-Magnet-Module möglich.

Eine nächste bevorzugte Ausführungsform der erfindungsgemäßen Kristallisationsanlage sieht vor, dass das zweite Heizer-Magnet-Modul aus einer Spule oder aus zwei oder mehr übereinander angeordneten Spulen mit spiralförmigen oder stufenförmigen Windungen gebildet ist oder das zweite Heizer-Magnet-Modul aus einer Spule mit mäanderförmiger Wicklung gebildet ist.

Die Spule mit der mäanderförmigen Wicklung ist ihrerseits eine "Mehrspulenanordnung" aus mindestens drei Mäandersegmenten, die zusammen einen Hohlzylinder bilden.

Wird die Kristallisationsanlage mit zwei ineinander gesteckten Heizer-Magnet-Modulen betrieben, kann das zweite innere Heizer-Magnet-Modul aus einer Mehrspulenanordnung aus zwei oder mehr übereinander angeordneten Spulen mit spiralförmigen Windungen aufgebaut sein oder aus einer Spulenkonstruktion mit mäanderförmigen Windungen bzw. Wicklungen bestehen. Mit dem zweiten tiegelnahen Heizer-Magnet-Modul wird ein magnetisches Wanderfeld oder - im Falle der mäanderförmigen Wicklung der Spule - ein azimutal rotierendes Magnetfeld erzeugt.

Mit dem als Mehrspulenanordnung aufgebauten Heizer-Magnet-Modul, das aus übereinander angeordneten Spulen mit spiralförmigen Windungen besteht, kann ein statisches oder ein Wanderfeld erzeugt werden. Mit dem Heizer-Magnet-Modul, welches aus einer Spule mit mäanderförmigen Wicklungen gebildet ist, kann ein azimutal rotierendes Magnetfeld erzeugt werden. Während das Wanderfeld zur Stabilisierung der Strömungen in Tiegelwandnähe und Einebnung der Kristallisationsfront dient, wird das rotierende Feld vorrangig zur Durchmischung der Schmelze genutzt. In beiden Heizer-Magnet-Modulen wird weiterhin simultan dazu die für den Aufschmelzvorgang erforderliche Joul'sche Wärme erzeugt.

In einer weiteren bevorzugten Ausführungsform der erfindungsgemäßen Kristallisationsanlage ist vorgesehen, dass das erste Heizer-Magnet-Modul lediglich eine Spule mit spiralförmig aufsteigenden Windungen und das zweite Heizer-Magnet-Modul eine Spule mit mäanderförmigen Wicklungen aufweist, wobei die Spule aus wenigstens drei Mäandersegmenten gebildet ist.

In dieser speziellen Anordnungsvariante kann das Heizer-Magnet-Modul mit lediglich einer Spule, das äußere bzw. tiegelfernere Heizer-Magnet-Modul, zur Beheizung des Tiegels und zur Erzeugung eines stationären Magnetfeldes verwendet werden. Mit dem zweiten tiegelnahen Heizer-Magnet-Modul, welches aus einer Spule mit mäanderförmigen Wicklungen gebildet ist, kann ein azimutal rotierendes Magnetfeld erzeugt werden.

Eine andere bevorzugte Ausführungsform der erfindungsgemäßen Kristallisationsanlage sieht vor, dass das erste Heizer-Magnet-Modul und das zweite Heizer-Magnet-Modul jeweils mindestens zwei übereinander angeordnete Spulen mit spiralförmigen Windungen aufweisen.

Diese Anordnungsvariante erlaubt die Erzeugung von zwei vertikal auf- oder abwärts laufenden magnetischen Wanderfeldern. Beispielsweise kann ein tiegelnahes vertikal aufwärts wanderndes Feld und ein tiegelferneres vertikal abwärts wanderndes Magnetfeld erzeugt werden.

Eine nächste bevorzugte Ausführungsform der erfindungsgemäßen Kristallisationsanlage sieht vor, dass die spiralförmigen Windungen der Spulen in gleiche oder entgegengesetzte Richtung aufsteigen und einen gleichen oder unterschiedlichen Windungsquerschnitt aufweisen.

Mit der erfindungsgemäßen Lösung wird die Trennung von Wärmeerzeugung und Magnetfelderzeugung erreicht. In einem von zwei ineinander gesteckten Heizer-Magnet-Modulen wird die Erzeugung von Wärme für den Aufschmelz- und Kristallisationsvorgang ausgeführt und im anderen Heizer-Magnet-Modul die Erzeugung eines Magnetfeldes vorgenommen. Dazu ist beispielsweise folgender Aufbau erforderlich: Das erste Heizer-Magnet-Modul besteht aus Spulen mit Windungen, die einen möglichst geringen Windungsquerschnitt aufweisen, um durch den hohen Widerstand einen großen Joul'schen Wärmebetrag zu erzeugen. Das zweite Heizer-Magnet-Modul besteht aus Spulen, die aus Windungen mit möglichst großem Querschnitt gefertigt sind, um auf Grund des geringen Widerstandes eine hohe Stromstärke für hohe Magnetfelder ohne merklichen Joul'schen Wärmebetrag durchzulassen.

In einer weiteren bevorzugten Ausführungsform der erfindungsgemäßen Kristallisationsanlage ist vorgesehen, dass die Anzahl der Spulen der Heizer-Magnet-Module und/oder die Windungsanzahl der Spulen gleich oder unterschiedlich sind.

Bei der Anordnungsvariante, bei dem das erste und das zweite Heizer-Magnet-Modul jeweils mindestens zwei übereinander angeordnete Spulen mit spiralförmigen Windungen aufweisen, kann die Spulenanzahl und die Windungszahl variieren.

In einer nächsten bevorzugten Ausführungsform der erfindungsgemäßen Kristallisationsanlage ist vorgesehen, dass an den Spulen der Heizer-Magnet-Module Stromzuführungen angeordnet sind, und die Spulen mit mindestens einer außerhalb der Züchtungskammer angeordneten Stromversorgungseinrichtung verbunden sind.

Die Stromzuführungen sind vorzugsweise in Form eines Winkelteiles, d. h. "kranförmig" ausgeführt. Sie sind erst nach einer unkritischen Distanz, die mindestens der Eindringtiefe des magnetischen Flusses bei der verwendeten Frequenz beträgt, abgewinkelt.

Eine andere bevorzugte Ausführungsform der erfindungsgemäßen Kristallisationsanlage sieht vor, dass die Heizer-Magnet-Module gegeneinander elektrisch isoliert und die Spulen elektrisch separat ansteuerbar sind.

Eine weitere bevorzugte Ausführungsform der erfindungsgemäßen Kristallisationsanlage sieht vor, dass zur elektrischen Isolierung ein zwischen den Heizer-Magnet-Modulen angeordnetes Isolierelement vorgesehen ist.

Das kann im einfachsten Fall ein Isolierring sein, welcher die Heizer-Magnet-Module elektrisch und räumlich voneinander trennt.

In einer nächsten bevorzugten Ausführungsform der erfindungsgemäßen Kristallisationsanlage ist vorgesehen, dass die Heizer-Magnet-Module gegeneinander elektrisch nicht isoliert sind und die Spulen gemeinsame Stromzuführungen aufweisen.

Mit einer solchen Verschaltung kann die Vergrößerung der Windungsbreite erreicht werden, indem die Windungen der ineinander gesteckten Heizer-Magnet-Module einen mehrlagigen Spulenkörper bilden.

In einer weiteren bevorzugten Ausführungsform der erfindungsgemäßen Kristallisationsanlage ist vorgesehen, dass an den spiralförmigen Windungen der Spulen der Heizer-Magnet-Module Stabilisierungselemente angeordnet sind.

Die Stabilisierungselemente aus Hochtemperaturkeramik unterstützen die mechanische Stabilität der aus spiralförmigen Windungen bestehenden Spulen und sorgen für äquidistante oder variable Windungsabstände.

Schließlich ist in einer bevorzugten Ausführungsform der erfindungsgemäßen Kristallisationsanlage vorgesehen, dass eine von den Spulen der Heizer-Magnet-Module umschlossene Fläche kreisrund oder viereckig ist.

Die Form der Heizer-Magnet-Module kann von der üblichen hohlzylindrischen Form mit kreisrunder Grundfläche abweichen. Die von den Spulen umschlossene Fläche kann insbesondere auch quadratisch sein. In diesem Fall hat der Schmelztiegel ebenfalls eine quadratische Grundfläche.

In einer bevorzugten Ausführungsform des erfindungsgemäßen Kristallisationsverfahrens ist vorgesehen, dass zwei in entgegengesetzter Richtung laufende wandernde Magnetfelder erzeugt werden, wobei das erste wandernde Magnetfeld bezogen auf den Tiegel aufwärts von unten nach oben und das zweite abwärts von oben nach unten wandert.

Das erfindungsgemäße Verfahren sieht vor, dass mindestens zwei voneinander unabhängige Wandermagnetfelder verschiedener Frequenzen und Phasenwinkel erzeugt werden können. Dazu ist erforderlich, dass die mindestens zwei ineinander gesteckten Heizer-Magnet-Module, die jeweils aus mehreren übereinander angeordneten Spulen besehen, elektrisch gegeneinander isoliert und über verschiedene Stromzuführungen versorgt werden. Die Richtung der beiden Wanderfelder kann dabei gegenläufig sein.

Eine andere bevorzugte Ausführungsform des erfindungsgemäßen Kristallisationsverfahrens sieht vor, dass die wandernden Magnetfelder mit jeweils verschiedenen Frequenzen erzeugt werden.

In einer nächsten bevorzugten Ausführungsform des erfindungsgemäßen Kristallisationsverfahrens ist vorgesehen, dass die Beheizung durch Einspeisung von Wechselstrom und/oder Gleichstrom ausgeführt wird.

Eine weitere bevorzugte Ausführungsform des erfindungsgemäßen Kristallisationsverfahrens sieht vor, dass die Erzeugung der Magnetfelder durch Steuerung der Größen Stromstärke, Phasenverschiebung und Frequenz ausgeführt wird.

Im Folgenden wird die Erfindung anhand von Zeichnungen und an einem Ausführungsbeispiel näher erläutert.

Es zeigen
- Fig. 1: eine vereinfachte schematische Schnitt-Darstellung eines Ausschnittes der erfindungsgemäßen Kristallisationsanlage,

- Fig. 2: eine schematische Darstellung von zwei ineinander angeordneten nicht elektrisch isolierten Heizer-Magnet-Modulen und
- Fig. 3: eine Explosionsdarstellung von zwei ineinander positionierbaren, elektrisch isolierten Heizer-Magnet-Modulen.

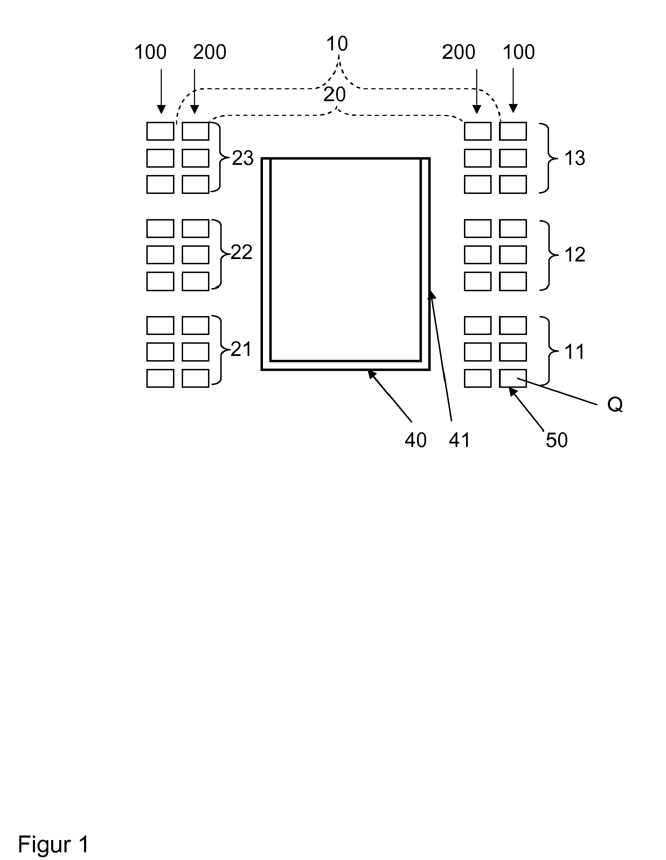

In Fig. 1 wird eine schematische und stark vereinfachte Darstellung eines Ausschnittes der erfindungsgemäßen Kristallisationsanlage im Querschnitt gezeigt.

Abgebildet sind zwei Heizer-Magnet-Module 100, 200, die um eine Tiegelwand 41 eines Tiegels 40 angeordnet sind. Das zweite Heizer-Magnet-Modul 200 befindet sich in einem Innenraum 10 des ersten Heizer-Magnet-Moduls 100. Der Tiegel 40 ist im Innenraum 20 des zweiten Heizer-Magnet-Moduls 100 angeordnet.

Die Heizer-Magnet-Module 100, 200 sind jeweils aus drei übereinander angeordneten Spulen 11, 12, 13, 21, 22, 23 aufgebaut. Die Spulen weisen jeweils drei Windungen 50 mit rechteckigem Querschnitt Q auf.

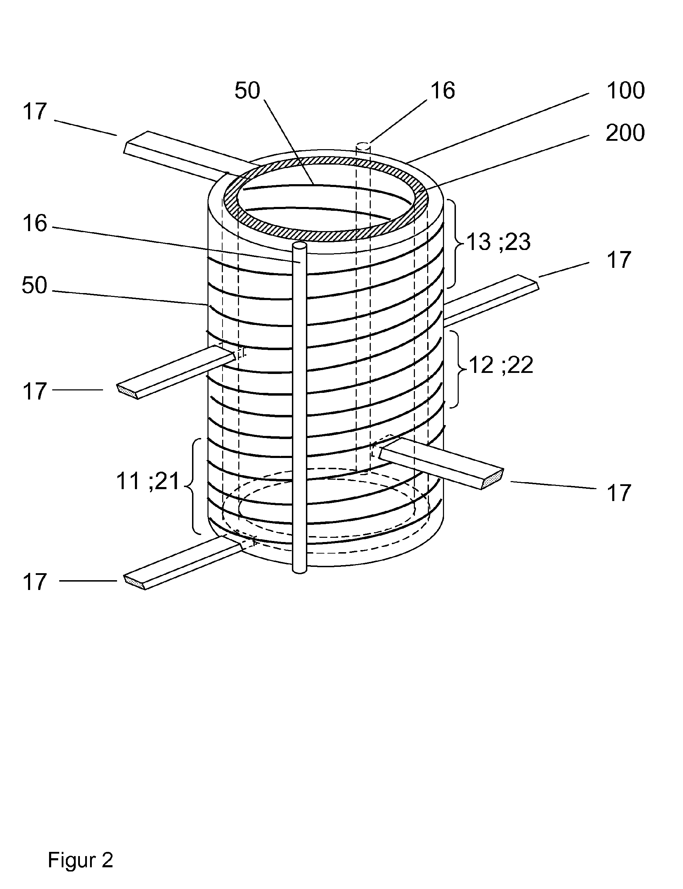

Figur 2 zeigt die schematische Darstellung von zwei ineinander angeordneten Heizer-Magnet-Modulen 100, 200.

Die Heizer-Magnet-Module 100, 200 sind aus einer Mehrspulenanordnung von jeweils drei übereinander angeordneten Spulen 11, 12, 13, 21, 22, 23 aus Reinstgraphit aufgebaut. Die Spulen 11, 12, 13, 21, 22, 23 weisen jeweils vier in gleichem Drehsinn aufsteigende spiralförmige Windungen 50 auf. Das zweite innere Heizer-Magnet-Modul 200 wird in dieser Darstellung lediglich durch eine Schraffur angedeutet. An den Spulen 11, 12, 13, 21, 22, 23 sind Stromzuführungen 17 angebracht. Zu erkennen ist, dass die Spulen 11, 12, 13, 21, 22, 23 der Heizer-Magnet-Module 100, 200 über gemeinsame Stromzuführungen 17 versorgt werden, d. h. die Heizer-Magnet-Module 100, 200 sind nicht elektrisch isoliert.

An den Windungen 50 des äußeren Heizer-Magnet-Moduls 100 sind Stabilisierungselemente 16 angeordnet.

Die Heizer-Magnet-Module 100, 200 sind eng ineinander gesteckt und parallel geschaltet, so dass wegen des nahezu verdoppelten Windungsquerschnitts Q und des dadurch verringerten Gesamtwiderstandes eine größere Stromstärke zur Generation einer stärkeren magnetischen Induktion ohne Entstehung einer Verlustwärme eingespeist werden kann. Die Windungsabstände werden mittels isolierender Stabilisierungselemente 16 mit periodischem Kammprofil stabil voneinander isoliert und äquidistant gehalten. Beide Heizer-Magnet-Module werden gleichzeitig mit einem Gleichstrom zur Erzeugung Joul'scher Wärme und einem Wechselstrom in Dreieck- oder Sternschaltung mit Phasenverschiebung zwischen 5 und 120° und der Frequenz f zwischen 10 und 600 Hz zur Erzeugung eines longitudinal laufenden magnetischen Wanderfeldes gespeist. Dabei werden die Stromstärken von Gleich- und Wechselstrom so abgestimmt, dass nur der Gleichstrom die zum Aufschmelzen erforderliche Wärmemenge und der Wechselstrom im Wesentlichen nur ein hinreichend effektives magnetisches Wanderfeld erzeugt.

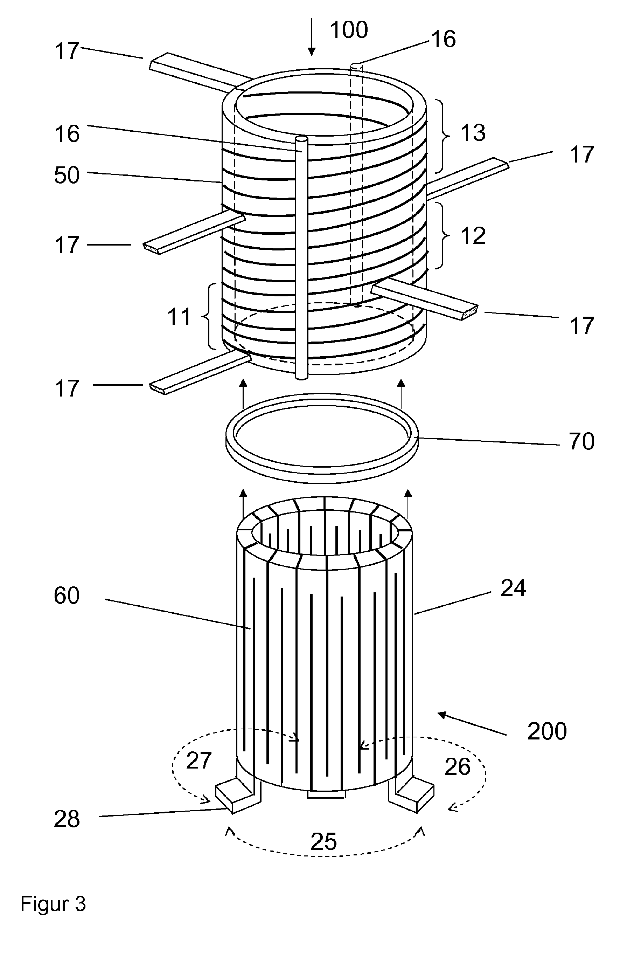

In Figur 3 wird die Explosionsdarstellung von zwei ineinander anordbaren Heizer-Magnet-Modulen gezeigt.

Das erste Heizer-Magnet-Modul 100 ist aus einer Mehrspulenanordnung von jeweils drei übereinander angeordneten Spulen 11, 12, 13 aufgebaut. Die Spulen 11, 12, 13 weisen jeweils vier spiralförmig aufsteigende Windungen 50 auf. An den Spulen 11, 12, 13 sind Stromzuführungen 17 und Stabilisierungselemente 16 angebracht.

Das zweite Heizer-Magnet-Modul 200, welches im Innenraum des ersten angeordnet wird, besteht aus einer Spule 24 mit mäanderförmigen Windungen (mäanderförmige Wicklung) 60. Die Spule 24 setzt sich aus drei Mäandersegmenten 25, 26, 27 zusammen, die durch Pfeile angedeutet werden. An den Mäandersegmenten 25, 26, 27 sind Stromzuführungen 28 für die Stromversorgung angebracht.

Beide Heizer-Magnet-Module 100, 200 sind über ein Isolierelement 70 voneinander elektrisch isoliert. Das Isolierelement 70 weist die Form eines Ringes aus elektrisch resistentem Material, wie z. B. BN, Al₂O₃, ZrO₂ oder Si₃N₄, auf.

Die Heizer-Magnet-Module 100, 200 besitzen jeweils eigene unabhängige Stromzuführungen 17, 28.

Für die Erzeugung Joul'scher Wärme zum Aufschmelzen des zu kristallisierenden Materials werden beide Heizer-Magnet-Module 100, 200 mit einem Gleichstrom gespeist. Gleichzeitig werden beide Heizer-Magnet-Module 100, 200 mit einem Wechselstrom bestimmter Frequenz f zwischen 10 und 600 Hz und Phasenverschiebung zwischen 5 und 120° beaufschlagt, wobei das erste Heizer-Magnet-Modul 100 vorteilhaft in Sternschaltung und das zweite Heizer-Magnet-Modul 200 in Dreieckschaltung verschaltet ist. Auf diese Weise wird mittels des ersten Heizer-Magnet-Moduls 100 ein auf- oder abwärts wanderndes Magnetfeld und mittels des zweiten Heizer-Magnet-Moduls 200 ein rechts- oder linksrotierendes Magnetfeld erzeugt. Die jeweiligen Feldrichtungen werden von der Richtung des Phasenschubs bestimmt, der in einer (hier nicht dargestellten) über Kontaktschienen verbundenen Einspeis- und Steuervorrichtung außerhalb des Züchtungskessels elektronisch vorgegeben wird.

### Bezugszeichenliste

- 100: erstes Heizer-Magnet-Modul
- 10: Innenraum
- 11: Spule
- 12: Spule
- 13: Spule
- 16: Stabilisierungselement
- 17: Stromzuführung

- 200: zweites Heizer-Magnet-Modul
- 20: Innenraum
- 21: Spule
- 22: Spule
- 23: Spule

- 24: Spule
- 25: Mäandersegment
- 26: Mäandersegment
- 27: Mäandersegment
- 28: Stromzuführung

- 40: Tiegel
- 41: Tiegelwand
- 50: Windungen
- 60: mäanderförmige Wicklung
- 70: Isolierelement

- Q: Windungsquerschnitt
- n: Anzahl Spulen
- z: Windungszahl

## Patentansprüche

1. Kristallisationsanlage mit elektrischer Heizeinrichtung, die als ein um eine Tiegelwand (41) eines Tiegels (40) herum positioniertes erstes Heizer-Magnet-Modul (100) ausgeführt ist,
**dadurch gekennzeichnet, dass**
im Innenraum (10) des ersten Heizer-Magnet-Moduls (100) ein zweites, ebenfalls um die Tiegelwand (41) des Tiegels (40) herum positioniertes Heizer-Magnet-Modul (200) angeordnet ist.

2. Kristallisationsanlage nach Anspruch 1, **dadurch gekennzeichnet, dass** weitere Heizer-Magnet-Module vorgesehen sind, die in Innenräumen (10, 20) eines jeweils vorhergehenden Heizer-Magnet-Moduls (200) positionierbar sind.

3. Kristallisationsanlage nach Anspruch 1, **dadurch gekennzeichnet, dass** das erste Heizer-Magnet-Modul (100) aus einer Spule (11) oder aus zwei oder mehr übereinander angeordneten Spulen (11, 12, 13) mit spiralförmigen oder stufenförmigen Windungen (50) gebildet ist.

4. Kristallisationsanlage nach Anspruch 1, **dadurch gekennzeichnet, dass** das zweite Heizer-Magnet-Modul (200) aus einer Spule (11) oder aus zwei oder mehr übereinander angeordneten Spulen (11, 12, 13) mit spiralförmigen oder stufenförmigen Windungen (50) gebildet ist oder das zweite Heizer-Magnet-Modul (200) aus einer Spule (24) mit mäanderförmiger Wicklung (60) gebildet ist.

5. Kristallisationsanlage nach Anspruch 1, **dadurch gekennzeichnet, dass** das erste Heizer-Magnet-Modul (100) lediglich eine Spule (11) mit spiralförmig aufsteigenden Windungen (50) und das zweite Heizer-Magnet-Modul (200) eine Spule (24) mit mäanderförmigen Wicklungen (60) aufweist, wobei die Spule (24) aus wenigstens drei Mäandersegmenten (25, 26, 27) gebildet ist.

6. Kristallisationsanlage nach Anspruch 1, **dadurch gekennzeichnet, dass** das erste Heizer-Magnet-Modul (100) und das zweite Heizer-Magnet-Modul (200) jeweils mindestens zwei übereinander angeordnete Spulen (11, 12, 13, 21, 22, 23) mit spiralförmigen Windungen (50) aufweisen.

7. Kristallisationsanlage nach einem der vorhergehenden Ansprüche, **dadurch gekennzeichnet, dass** die Heizer-Magnet-Module (100, 200) gegeneinander elektrisch isoliert und die Spulen (11, 12, 13, 21, 22, 23, 24) elektrisch separat ansteuerbar sind.

8. Kristallisationsanlage nach Anspruch 7, **dadurch gekennzeichnet, dass** zur elektrischen Isolierung ein zwischen den Heizer-Magnet-Modulen (100, 200) angeordnetes Isolierelement (70) vorgesehen ist.

9. Kristallisationsanlage nach einem der Ansprüche 1 bis 6, **dadurch gekennzeichnet, dass** die Heizer-Magnet-Module (100, 200) gegeneinander elektrisch nicht isoliert sind und die Spulen (11, 12, 13, 21, 22, 23, 24) gemeinsame Stromzuführungen (17) aufweisen.

10. Kristallisationsanlage nach Anspruch 3, **dadurch gekennzeichnet, dass** an den spiralförmigen Windungen (50) der Spulen (11, 12, 13, 21, 22, 23) der Heizer-Magnet-Module (100, 200) Stabilisierungselemente (16, 28) angeordnet sind.

11. Kristallisationsanlage nach einem der vorhergehenden Ansprüche, **dadurch gekennzeichnet, dass** eine von den Spulen (11, 12, 13, 21, 22, 23, 24) der Heizer-Magnet-Module (100, 200) umschlossene Fläche kreisrund oder viereckig ist.

12. Kristallisationsverfahren aus elektrisch leitenden Schmelzen, bei dem eine in einem Tiegel (40) enthaltene Schmelze mit einer Kristallisationsanlage nach einem der Ansprüche 1 bis 11 elektrisch beheizt wird und zusätzlich wandernde auf die Schmelze einwirkende Magnetfelder erzeugt werden, **dadurch gekennzeichnet, dass**
(i) bezogen auf den Tiegel (40) mindestens ein vertikal aufwärts oder abwärts wanderndes Magnetfeld und gleichzeitig ein weiteres azimutal rotierendes Magnetfeld erzeugt werden oder
(ii) bezogen auf den Tiegel (40) ein azimutal rotierendes Magnetfeld und gleichzeitig ein weiteres stationäres Magnetfeld erzeugt werden
oder
(iii) ein erstes vertikal aufwärts oder abwärts wanderndes Magnetfeld und gleichzeitig mindestens ein weiteres vertikal aufwärts oder abwärts wanderndes Magnetfeld erzeugt werden.

13. Kristallisationsverfahren nach Variante (iii) aus Anspruch 12, **dadurch gekennzeichnet, dass** zwei in entgegengesetzter Richtung laufende wandernde Magnetfelder erzeugt werden, wobei das erste wandernde Magnetfeld bezogen auf den Tiegel (40) aufwärts von unten nach oben und das zweite abwärts von oben nach unten wandert.

14. Kristallisationsverfahren nach Anspruch 13, **dadurch gekennzeichnet, dass** die wandernden Magnetfelder mit jeweils verschiedenen Frequenzen erzeugt werden.

15. Kristallisationsverfahren nach Anspruch 12, **dadurch gekennzeichnet, dass** die Beheizung durch Einspeisung von Wechselstrom und/oder Gleichstrom ausgeführt wird.

16. Kristallisationsverfahren nach Anspruch 12, **dadurch gekennzeichnet, dass** die Erzeugung der Magnetfelder durch Steuerung der Stromstärke, Phasenverschiebung und Frequenz erfolgt.
